(19) Europäisches Patentamt / European Patent Office / Office européen des brevets

(11) **EP 2 299 536 A1**

(12) **EUROPEAN PATENT APPLICATION**
published in accordance with Art. 153(4) EPC

(43) Date of publication:
**23.03.2011 Bulletin 2011/12**

(21) Application number: **09766762.0**

(22) Date of filing: **12.08.2009**

(51) Int Cl.:
**H01M 14/00** *(2006.01)*    **H01L 31/04** *(2006.01)*

(86) International application number:
**PCT/JP2009/064265**

(87) International publication number:
**WO 2009/154314 (23.12.2009 Gazette 2009/52)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **17.06.2008 JP 2008157645**
**19.09.2008 JP 2008240955**
**03.10.2008 JP 2008258761**

(71) Applicant: **Nippon Electric Glass Co., Ltd.**
**Otsu-shi**
**Shiga 520-8639 (JP)**

(72) Inventors:
• **SAWADA, Masahiro**
**Otsu-shi**
**Shiga 520-8639 (JP)**

• **NAGAKANE, Tomohiro**
**Otsu-shi**
**Shiga 520-8639 (JP)**
• **SAKAMOTO, Akihiko**
**Otsu-shi**
**Shiga 520-8639 (JP)**
• **SETO, Tadashi**
**Otsu-shi**
**Shiga 520-8639 (JP)**
• **FUJIMOTO, Satoshi**
**Otsu-shi**
**Shiga 520-8639 (JP)**

(74) Representative: **Henkel, Feiler & Hänzel**
**Patentanwälte**
**Maximiliansplatz 21**
**80333 München (DE)**

(54) **SUBSTRATE FOR SOLAR CELL AND OXIDE SEMICONDUCTOR ELECTRODE FOR DYE-SENSITIZED SOLAR CELL**

(57)    Provided is a solar cell substrate which is composed of a transparent conductive film formed on a glass substrate, wherein the thermal expansion coefficient of the glass substrate is $50 \times 10^{-7}$ to $110 \times 10^{-7}/°C$. Also provided is a solar cell substrate in which a conductive film composed of a fluorine-doped tin oxide or an antimony-doped tin oxide is deposited on a glass substrate having a thickness of 0.05 to 2 mm, wherein the strain point of the glass substrate is 525°C or higher.

EP 2 299 536 A1

**Description**

TECHNICAL FIELD

The present invention relates to a solar cell substrate, and to an oxide semiconductor electrode for dye-sensitized solar cell using the solar cell substrate.

BACKGROUND ART

These days the demand for solar cells such as typically monocrystalline silicon or polycrystalline silicon solar cells or amorphous silicon solar cells is increasing more and more. These solar cells are utilized mainly for home electrical power generation, commercial electrical power generation, and the like. Other solar cells such as CIS solar cells, CdTe solar cells, dye-sensitized solar cells, organic thin film solar cells and the like have been developed, and these are also being put into practical use.

In amorphous silicon solar cells and dye-sensitized solar cells, a transparent conductive film-deposited glass substrate is used as the electrode substrate. As the glass substrate, soda lime glass is generally used, because it is advantageous in point of the production cost and the versatility. As the transparent conductive film, fluorine-doped tin oxide (FTO), antimony-doped tin oxide (ATO), tin-doped indium oxide (ITO), and the like, are used. Above all, FTO and ATO are chemically and thermally stable, though inferior to ITO in point of the resistivity, and are expected to have the effect of trapping light owing to the film surface asperity and the effect of enhancing the conductivity owing to the increased surface area; and therefore, they are widely used for electrode substrates for amorphous silicon solar cells and dye-sensitized solar cells (for example, see Patent Reference 1 and Non-Patent Reference 1).

In general, for formation of an FTO film and an ATO film, a thermal chemical vapor deposition (thermal CVD) method is used, because its film formability is excellent and its cost is low. Concretely, a mixed gas of compounds containing tin and fluorine is thermally decomposed on a glass substrate heated at about 480°C or higher, thereby forming a film. In this connection, the thermal CVD method includes an on-line CVD method where the heat in a sheet glass production line is utilized for film formation, and an off-line CVD method where glass is once cooled and cut to have a predetermined dimension and is again heated for film formation.

With the recent popularization of mobile electronic appliances, solar cells have become used as a power source in addition to ordinary batteries. In case where solar cells are used in mobile electronic appliances, they are required to be thinner and more lightweight than solar cells for use for conventional, outdoor-installed home or commercial power-generation facilities. In addition, they are also required to have a high power generation efficiency with any other light than direct sunlight, such as room light and the like. For such applications, dye-sensitized solar cells are especially suitable.

For reducing the thickness and the weight of solar cells, it is most effective to thin the electrode substrate. In order to thin the electrode substrate, for example, a method of grinding and thinning the glass substrate that constitutes the electrode substrate is exemplified. In general, in case where glass is ground, both surfaces thereof are ground for the reason of time reduction and cost reduction. However, in case where a conductive film is formed on one side of a glass substrate, only the other side thereof can be ground, thereby taking time and cost. Another problem is that the conductive film may be readily flawed in the grinding step.

Accordingly, a method in which a thin-sheet glass substrate is prepared previously and then a conductive film is formed on the surface thereof is proposed. The method does not require an operation of grinding the glass substrate, therefore saving time and cost and realizing efficient thickness reduction and weight reduction of solar cells.

RELATED ART REFERENCES

Patent Reference

Patent Reference 1: JP-A 2002-260448
Non-Patent Reference
Non-Patent Reference 1: Technology of Transparent Conductive Film (revised 2nd edition), Ohmsha, Ltd., p. 153-165

EP 2 299 536 A1

## SUMMARY OF THE INVENTION

### PROBLEMS THAT THE INVENTION IS TO SOLVE

In a dye-sensitized solar cell, an oxide semiconductor electrode having an oxide semiconductor layer of titanium oxide, zinc oxide or the like formed on a transparent conductive film-deposited substrate (conductive film surface) is used. In this, when the adhesiveness between the oxide semiconductor layer and the conductive film-deposited substrate (conductive film surface) is enhanced, then the energy conversion efficiency of the solar cell is increased. However, depending on the type of the substrate, the oxide semiconductor layer may readily peel away from the conductive film-deposited substrate (conductive film surface), and there may be a problem in that the predetermined properties can not be obtained.

Accordingly, the present invention has been made in consideration of the above-mentioned situation, and the first object thereof is to provide a solar cell substrate in which an oxide semiconductor layer hardly peels away, and to provide an oxide semiconductor electrode for dye-sensitized solar cell using said the solar cell substrate.

As already described above, in the case of forming an FTO film or an ATO film on a glass substrate according to an off-line CVD method, the glass substrate is heated up to about 480˚C or higher for film formation. However, the temperature of the gas to be sprayed onto the glass substrate is relatively low, and therefore, the temperature of the glass substrate tends to lower by film formation. As a result, when the glass substrate has some uneven temperature distribution in the plane direction or the thickness direction, then it may be stressed and may be thereby deformed. Accordingly, in case where the glass substrate is fully thick like before, it is hardly deformed; however, in case where the substrate is thin, especially when its thickness is 2 mm or less, its deformation may be remarkable, and there has been a problem in that the substrate can no more be usable as a solar cell electrode substrate.

Accordingly, the second object of the present invention is to provide a solar cell substrate which is hardly deformed in formation of an FTO film or an ATO film, and to provide an oxide semiconductor electrode for dye-sensitized solar cell using said solar cell substrate.

### MEANS FOR SOLVING THE PROBLEMS

The present inventors have intensively investigated the first object above and, as a result, have found that the thermal expansion coefficient of the glass substrate for use in a solar cell substrate has a relation with the easiness in peeling of the oxide semiconductor layer, and have completed the present invention.

That is, the first aspect of the present invention is a solar cell substrate having a transparent conductive film formed on a glass substrate, wherein the thermal expansion coefficient of the glass substrate is from $50 \times 10^{-7}$ to $110 \times 10^{-7}$/˚C. In the present invention, the thermal expansion coefficient of the glass substrate is a value measured according to JIS R3103 within a range of from 30 to 380˚C.

The reasons for the correlation between the thermal expansion coefficient of the glass substrate and the easiness in peeling of the oxide semiconductor layer are described below.

Formation of an oxide semiconductor layer on a glass substrate (conductive film surface) takes a process that comprises applying a paste or slurry containing oxide particles onto a glass substrate with a conductive film formed thereon (conductive film surface), followed by heat-treating (baking) at from 400 to 600˚C, preferably from 420 to 570˚C, more preferably from 450 to 550˚C to thereby sinter the oxide particles. In this process, the oxide semiconductor layer shrinks along with sintering of the oxide particles, therefore providing a stress between the glass substrate (on the conductive film side) and the oxide semiconductor layer, and this stress causes the peeling of the oxide semiconductor layer. This stress is larger when the oxide semiconductor layer is thicker and when the glass substrate is thicker. Accordingly, by controlling the thermal expansion coefficient of the glass substrate layer to fall within the above range, the stress to act between the glass substrate (on the conductive film side) and the oxide semiconductor layer can be relaxed owing to the shrinkage of the glass substrate in cooling from the maximum temperature to room temperature during the heat treatment and the peeling of the oxide semiconductor layer may be thereby prevented.

The solar cell substrate of the first aspect of the present invention can be used as the substrate for dye-sensitized solar cell.

In addition, in the solar cell substrate of the first aspect of the present invention, the strain point of the glass substrate is preferably 525˚C or higher. In the present invention, the strain point is a value measured according to JIS R3103.

Controlling the strain point of the glass substrate to be 525˚C or higher like this makes it possible to prevent the thermal deformation of the glass substrate in the heating step in conductive film formation and in the sintering step of the oxide semiconductor layer. As described above, the stress to act between the glass substrate (on the conductive film side) and the oxide semiconductor layer is larger when the glass substrate is thicker, and therefore, the thickness of the glass substrate is preferably smaller. However, when the glass substrate is thin, then there is a problem that the glass substrate may readily undergo thermal deformation in the sintering step. From this situation, controlling the strain point of the glass substrate to be 525˚C or higher is especially effective in the case where the glass substrate is thin.

Further, in the solar cell substrate of the first aspect of the present invention, the thickness of the glass substrate is preferably at most 2 mm.

In addition, the present invention relates to an oxide semiconductor electrode for dye-sensitized solar cell comprising an oxide semiconductor layer having a thickness of from 5 to 50 $\mu$m formed on the transparent conductive film of the above solar cell substrate of the first aspect.

Here, in the above oxide semiconductor electrode for dye-sensitized solar cell, the oxide semiconductor layer preferably contains titanium oxide.

In addition, in the above oxide semiconductor electrode for dye-sensitized solar cell, the oxide semiconductor layer preferably is composed of plural layers having different light transmittance.

As described later, preferably, the oxide semiconductor layer is composed of at least two kinds having different light transmittance, for effective utilization of radiated light. In said constitution, the stress to act between the oxide semiconductor layer and the glass substrate (on the conductive film side) tends to increase owing to the difference in the sintering behavior in the constitutive layers, and therefore the effect of the present invention can be attained easily.

In addition, in the above oxide semiconductor electrode for dye-sensitized solar cell, the oxide semiconductor layer preferably is composed of plural layers having different particle size distribution of the oxide particles.

Further, in the above oxide semiconductor electrode for dye-sensitized solar cell, the oxide semiconductor layer preferably comprises a layer comprising oxide particles having a mean primary particle size of at most 30 nm.

Further, the present inventors have also intensively investigated the second object mentioned above and, as a result, have found that, in the solar cell substrate having an FTO film or an ATO film formed on a thin-sheet glass substrate, when the strain point of the glass substrate is defined to fall within a predetermined range, then the above-mentioned object can be attained, and have completed the present invention.

That is, the solar cell substrate of the second aspect of the present invention comprises a conductive film of fluorine-doped tin oxide or antimony-doped tin oxide formed on a glass substrate having a thickness of from 0.05 to 2 mm, wherein the strain point of the glass substrate is 525˚C or higher. In the present invention, the strain point of the glass substrate is a value measured according to JIS R3103.

The temperature for film formation of the FTO film and the ATO film may vary depending on the materials to be used for film formation and the thickness of the film, but, for example, in a case of a thermal CVD method, the temperature may be around 480˚C or higher. When the glass substrate temperature is lower than 480˚C, it is unfavorable for practical use since the film formation speed may be extremely low. With the elevation of the substrate temperature, the film formation speed may be higher and at the same time the film surface may be roughened more. This film surface asperity contributes toward enhancing the light trapping effect and increasing the surface area, therefore bringing about conductivity enhancement. For attaining an excellent film formation speed and an excellent film surface condition, the film formation temperature is preferably 510˚C or higher. In particular, the glass substrate for use in the present invention is extremely thin, having a thickness of from 0.05 to 2 mm, and may readily undergo thermal deformation in film formation of a conductive film; however, when the strain point of the glass substrate is 525˚C or higher, which is sufficiently higher than the film formation temperature, then the glass substrate can be prevented from deforming in film formation of a conductive film.

The solar cell substrate of the second aspect of the present invention can be used in a dye-sensitized solar cell.

The dye-sensitized solar cell comprises a conductive film-deposited glass substrate, a porous oxide semiconductor electrode of a porous oxide semiconductor layer (mainly $TiO_2$ layer) formed on the conductive film-deposited glass substrate (on the conductive film), a dye such as an Ru dye or the like adsorbed to the porous oxide semiconductor electrode, an iodine electrolytic solution containing iodine, a counter electrode substrate with a catalyst film and a transparent conductive film formed thereon, and the like.

In the dye-sensitized solar cell, a conductive film such as an FTO film, an ATO film or the like is formed on a glass substrate, and then a porous oxide semiconductor layer is further formed on the conductive film-deposited glass substrate (on the conductive film) at a heating temperature of around 500˚C. In general, the upper limit of the heat resistant temperature of the conductive film formed on the glass substrate depends on the film formation temperature. Accordingly, when the film formation temperature for the conductive film is around 500˚C, then the film properties may change in the step of forming the porous oxide semiconductor layer, and especially the resistivity may increase and the energy conversion efficiency may be thereby lowered. In the present invention, the strain point of the glass substrate is 525˚C or higher, and therefore, film formation of a conductive film at a higher temperature is possible as compared with the substrate of conventional soda lime glass or the like, and the film properties hardly change in the step of forming the porous oxide semiconductor layer. Accordingly, the solar cell substrate of the present invention is favorable as dye-sensitized solar cells.

As compared with an ITO film, the film surface asperity of the FTO film and the ATO film is larger, and therefore these films are expected to exhibit an effect of sufficiently fixing the porous oxide semiconductor layer such as a $TiO_2$

layer or the like (anchor effect).

In the solar cell substrate of the second aspect of the present invention, the thermal expansion coefficient of the glass substrate is preferably from $70 \times 10^{-7}$ to $110 \times 10^{-7}/°C$. In the present invention, the thermal expansion coefficient of the glass substrate is the thermal expansion coefficient measured according to JIS R3103 within a range of from 30 to 380°C.

For example, in a dye-sensitized solar cell, the outer periphery of the conductive film-deposited glass substrate and the counter electrode substrate must be sealed up with a resin or low-melting-point glass such as lead glass, bismuth borate glass or the like, for preventing the leakage of the iodine electrolytic solution filled between the conductive film-deposited glass substrate and the counter electrode substrate. In the case of sealing with low-melting-point glass, when the difference in the thermal expansion coefficient between the low-melting-point glass and the glass substrate is too large, the sealed part or the glass substrate may be cracked therefore causing leakage of iodine electrolytic solution. The low-melting-point glass such as lead glass, bismuth borate glass or the like generally has a large thermal expansion coefficient, for which, therefore, employed is a method of adding thereto a refractory filler to thereby lower the thermal expansion coefficient and reduce the thermal expansion coefficient difference from the glass substrate.

Recently, for consideration for environmental protection, lead-free glass has become used as the sealant. However, as compared with lead glass, it is difficult to lower the thermal expansion coefficient of bismuth borate glass, and its application to a low-thermal-expansion glass substrate is difficult. Accordingly, in the second aspect of the present invention, the thermal expansion coefficient of the glass substrate is limited to be $70 \times 10^{-7}/°C$ or higher, falling within a relatively high-value range, and therefore sealing with bismuth borate glass substrate is easy, and a dye-sensitized solar cell favorable from the viewpoint of environmental protection is provided.

On the other hand, by defining the thermal expansion coefficient of the glass substrate to be $110 \times 10^{-7}/°C$ or lower, it is possible to prevent the substrate from being thermally deformed or broken during film formation of an FTO film or an ATO film.

In addition, the present invention relates to an oxide semiconductor electrode for dye-sensitized solar cell comprising an oxide semiconductor layer having a thickness of from 5 to 50 $\mu$m formed on the conductive film of the above solar cell substrate of the second aspect.

Here, in the oxide semiconductor electrode for dye-sensitized solar cell of the second aspect of the present invention, the oxide semiconductor layer preferably comprises oxide particles having a mean primary particle size of at most 30 nm.

In that manner, the mean primary particle size of the oxide particles constituting the oxide semiconductor layer is reduced, whereby the light transmittance of the oxide semiconductor layer can be increased.

In addition, in the oxide semiconductor electrode for dye-sensitized solar cell of the second aspect of the present invention, the porosity of the oxide semiconductor layer is preferably from 60 to 80%.

The porosity of the oxide semiconductor layer is defined to fall within the range, whereby the stress to act may be relaxed and the dye adsorption may be attained sufficiently. In the present invention, the porosity of the oxide semiconductor layer is computed according to the following formula:

$$\rho = W/V$$

$$P = (1 - \rho/D) \times 100 \ [\%]$$

wherein W means the mass of the oxide semiconductor layer; V means the volume of the oxide semiconductor layer; $\rho$ means the apparent density of the oxide semiconductor layer; D means the theoretical density of the oxide semiconductor; and P means the porosity of the oxide semiconductor layer.

EFFECT OF THE INVENTION

According to the present invention, a solar cell substrate especially useful for dye-sensitized solar cells, in which the oxide semiconductor layer is prevented from peeling away, or the glass substrate is prevented from deforming in film formation of a conductive film, is provided.

## BEST MODE FOR CARRYING OUT THE INVENTION

First, the first aspect of the present invention is described in detail.

In the solar cell substrate of the first aspect of the present invention, the thermal expansion coefficient of the glass substrate is from $50 \times 10^{-7}$ to $110 \times 10^{-7}/°C$, preferably from $55 \times 10^{-7}$ to $100 \times 10^{-7}/°C$, more preferably from $60 \times 10^{-7}$ to $95 \times 10^{-7}/°C$. When the thermal expansion coefficient of the glass substrate is less than $50 \times 10^{-7}/°C$, then the effect of reducing the stress to act between the glass substrate (on the conductive film side) and the oxide semiconductor layer may be low and the oxide semiconductor layer may readily peel away, as so mentioned in the above. On the other hand, when the thermal expansion coefficient of the glass substrate is more than $110 \times 10^{-7}/°C$, then the stress to be caused by the thermal expansion of the glass substrate may be large in the baking of the oxide semiconductor layer and the oxide semiconductor layer may readily peel away.

The strain point of the glass substrate is preferably 525°C or higher, 540°C or higher, particularly 560°C or higher. When the strain point of the glass substrate is lower than 525°C, then the glass substrate may readily undergo thermal deformation in the heating step for conductive film formation and in the baking step of the oxide semiconductor layer.

Further, as mentioned in the above, the thickness of the glass substrate is preferably at most 2 mm, at most 1.8 mm, particularly at most 1.5 mm, for the purpose to keep the stress to act between the glass substrate (on the conductive film side) and the oxide semiconductor layer low.

In the solar cell substrate of the present invention, the material of the glass substrate includes $SiO_2$-RO-R'$_2$O-based glass, $SiO_2$-$Al_2O_3$-RO-R'$_2$O-based glass, $SiO_2$-$Al_2O_3$-RO-based glass, $SiO_2$-$Al_2O_3$-$B_2O_3$-RO-based glass, $SiO_2$-$Al_2O_3$-R'$_2$O-based glass, $SiO_2$-$B_2O_3$-R'$_2$O-based glass, $SiO_2$-$B_2O_3$-$Al_2O_3$-RO-R'$_2$O-based glass and the like (wherein R means at least one of Mg, Ca, Sr, Ba and Zn; R' means at least one of Li, Na and K). In the present invention, the expression "...-based glass" means the glass containing the corresponding ingredients as the indispensable ingredients.

Here, R'$_2$O is an ingredient that increases the thermal expansion coefficient and facilitates glass melting, but at the same time it tends to lower the strain point. Like R'$_2$O, RO is also an ingredient that increases the thermal expansion coefficient and facilitates glass melting, but as compared with R'$_2$O, does not so much lower the strain point. Accordingly, by suitably substituting these ingredients, the thermal expansion coefficient and the strain point can be controlled to fall within a preferred range, at the same time the glass melting can be facilitated.

For instance, as $SiO_2$-$Al_2O_3$-RO-R'$_2$O-based glass, a composition of, in terms of % by mass, from 50 to 70% of $SiO_2$, from 0.5 to 15% of $Al_2O_3$, from 10 to 27% of $MgO + CaO + SrO + BaO + ZnO$, from 7 to 15% of $Li_2O + Na_2O + K_2O$, from 0 to 9% of $ZrO_2$, from 0 to 5% of $TiO_2$, and from 0 to 1% of $SnO_2 + Sb_2O_3 + As_2O_3 + SO_3$, is exemplified.

The reason for the definition of the glass composition could be explained as follows.

$SiO_2$ is a network-constituting ingredient of glass, and its content is from 50 to 70%, preferably from 52 to 65%. When the $SiO_2$ content is less than 50%, then the strain point tends to be low. On the other hand, when the $SiO_2$ content is more than 70%, then the thermal expansion coefficient may be too low and the meltability may worsen and the composition may readily devitrify.

$Al_2O_3$ is an ingredient for elevating the strain point, and its content is from 0.5 to 15%, preferably from 2 to 12%. When the $Al_2O_3$ content is less than 0.5%, then the effect of elevating the strain point could hardly be attained. On the other hand, when the $Al_2O_3$ content is more than 15%, then the melting temperature becomes high and the meltability may worsen and the composition may readily devitrify.

MgO, CaO, SrO, BaO and ZnO are all ingredients for enhancing the meltability of glass and for controlling the thermal expansion coefficient. As already described, these ingredients have a property not to lower the strain point so much as compared with alkali metal oxides. The content of these ingredients is from 10 to 27% in total, preferably from 15 to 25%. When the total content of these ingredients is less than 10%, then the melting temperature becomes high and the meltability may worsen; on the other hand however, when more than 27%, then the composition may readily devitrify and its forming becomes difficult.

$Li_2O$, $Na_2O$ and $K_2O$ are all ingredients for enhancing the meltability of glass, at the same time for controlling the thermal expansion coefficient. The content of these ingredients is from 7 to 15% in total, preferably from 8 to 13%. When the total content of these ingredients is less than 7%, then the melting temperature becomes high and the meltability may worsen; on the other hand however, when more than 15%, then the strain point may be low.

$ZrO_2$ is an ingredient for elevating the strain point and for enhancing the chemical durability. The content of $ZrO_2$ is from 0 to 9%, preferably from 1 to 7%. When the $ZrO_2$ content is more than 9%, then a devitrified matter may form in melting and the composition may be difficult to be formed.

$TiO_2$ is an ingredient for preventing glass from being colored by UV rays (solarization). In case where the glass substrate contains an iron ion as an impurity (for example, in an amount of from 0.01 to 0.2%) and when the solar cell is used for a long period of time, then the iron ion may cause coloration. Thus, adding $TiO_2$ to the glass composition may prevent the coloration of this type. The $TiO_2$ content is from 0 to 5%, preferably from 1 to 4%. When the $TiO_2$ content

is more than 5%, then the composition may readily devitrify and its forming may be difficult.

$SnO_2$, $Sb_2O_3$, $As_2O_3$ and $SO_3$ are all ingredients serving as a fining agent. The content of these ingredients is from 0 to 1% in total, preferably from 0.1 to 0.8%. When the total content of these ingredients is more than 1%, then the composition may readily devitrify and its forming may be difficult.

As $SiO_2$-$Al_2O_3$-RO-based glass, a composition of, in terms of % by mass, from 30 to 50% of $SiO_2$ from 0.5 to 15% of $Al_2O_3$, from 30 to 60% of MgO + CaO + SrO + BaO + ZnO, from 0 to 10% of $B_2O_3$, from 0 to 5% of $ZrO_2$, from 0 to 5% of $TiO_2$, and from 0 to 1% of $SnO_2 + Sub_2O_3 + As_2O_3 + SO_3$, is exemplified.

$SiO_2$ is a network-constituting ingredient of glass, and its content is from 30 to 50%, preferably from 32 to 42%. When the $SiO_2$ content is less than 32%, then the composition would be difficult to vitrify. On the other hand, when the $SiO_2$ content is more than 42%, then the thermal expansion coefficient may be too low and the meltability may worsen and the composition may readily devitrify.

$Al_2O_3$ is an ingredient for elevating the strain point of glass, and its content is from 0.5 to 15%, preferably from 2 to 10%. When the $Al_2O_3$ content is less than 0.5%, then the effect of elevating the strain point could hardly be attained. On the other hand, when the $Al_2O_3$ content is more than 10%, then the melting temperature becomes high and the meltability may worsen and the composition may readily devitrify.

MgO, CaO, SrO, BaO and ZnO are all ingredients for enhancing the meltability of glass, at the same time for controlling the thermal expansion coefficient. As already described, these ingredients have a property not to lower the strain point so much as compared with alkali metal oxides. The content of these ingredients is from 30 to 60% in total, preferably from 35 to 50%. When the total content of these ingredients is less than 30%, then the melting temperature becomes high and the meltability may worsen; on the other hand however, when more than 60%, then the composition may readily devitrify and its forming may be difficult.

$B_2O_3$ is an ingredient for lowering the high-temperature viscosity of glass, at the same time for inhibiting the devitrification of glass. Its content is from 0 to 10%, preferably from 1 to 8%. When the $B_2O_3$ content is more than 10%, then it is unfavorable since the thermal expansion coefficient becomes lower too much.

$ZrO_2$ is an ingredient for elevating the strain point and for enhancing the chemical durability. The content of $ZrO_2$ is from 0 to 9%, preferably from 1 to 7%. When the $ZrO_2$ content is more than 9%, then a devitrified matter forms in melting and the composition may be difficult to be formed.

$TiO_2$ is an ingredient for preventing glass from being colored by UV rays (solarization). In case where the glass substrate contains an iron ion as an impurity (for example, in an amount of from 0.01 to 0.2%) and when the solar cell comprising the glass substrate is used for a long period of time, then the iron ion may cause coloration. Thus, adding $TiO_2$ thereto may prevent the coloration of this type. The $TiO_2$ content is from 0 to 5%, preferably from 1 to 4%. When the $TiO_2$ content is more than 5%, then the composition may readily devitrify and its forming may be difficult.

$SnO_2$, $Sb_2O_3$, $As_2O_3$ and $SO_3$ are all ingredients serving as a fining agent. The content of these ingredients is from 0 to 1% in total, preferably from 0.1 to 0.8%. When the total content of these ingredients is more than 1%, then the composition may readily devitrify and its forming may be difficult.

The material constituting the conductive film is preferably fluorine-doped tin oxide (FTO), antimony-doped tin oxide (ATO), tin-doped indium oxide (ITO) or the like. Above all, FTO and ATO are chemically and thermally stable, though inferior to ITO in point of the resistivity, and are favorable as expected to have the effect of trapping light owing to the film surface asperity and the effect of enhancing the conductivity owing to the increased surface area.

Regarding the staring materials for the FTO film and the ATO film to be formed according to a film formation method such as a thermal CVD method or the like, $SnCl_4$, $C_4H_9SnCl_3$, $(CH_3)_2SnCl_2$ and the like can be used as the tin source; HF, $CF_3COOH$, $CHF_2$, $CCl_2F_2$ and the like can be used as the fluorine source; and $SbCl_3$ and the like can be used as the antimony source.

The thickness of the FTO film and the ATO film is not particularly limited, but is preferably controlled to fall within a range of from 0.5 to 1.5 $\mu$m. When the thickness of the FTO film and the ATO film is less than 0.5 $\mu$m, then sufficient conductivity can not be attained; on the other hand however, when more than 1.5 $\mu$m, then the sunlight spectral transmittance may be low, and the power generation efficiency of the solar cell may lower.

The resistance of the FTO film and the ATO film is preferably at most 10 $\Omega$/square, more preferably at most 7 $\Omega$/square, When the resistance of the film is more than 10 $\Omega$/square, then the conductivity may lower and the performance as the solar cell tends to worsen.

The mean surface roughness (Ra) of the FTO film and the ATO film is preferably at least 20 nm, more preferably at least 30 nm. The mean surface roughness of the film falling within the range facilitates the light trapping effect and increases the surface area of the film, therefore enhancing the conductivity.

In case where the glass substrate comprises glass that contains an alkali metal oxide, an undercoat layer of $SiO_2$ or the like may be provided between the FTO film or the ATO film and the glass substrate. Such an undercoat layer prevents the situations in which alkali ion is eluted from glass to lower the conductivity of the FTO film or the ATO film or problems of pin hole formation or film thickness distribution unevenness are caused.

In the oxide semiconductor electrode for dye-sensitized solar cell of the present invention, the thickness of the oxide semiconductor layer is from 5 to 50 $\mu$m, preferably from 8 to 40 $\mu$m, more preferably from 10 to 30 $\mu$m. When the thickness of the oxide semiconductor layer is less than 5 $\mu$m, then the power generation efficiency of the dye-sensitized solar cell may lower. On the other hand, when the thickness of the oxide semiconductor layer is more than 50 $\mu$m, it is difficult to utilize the radiated light efficiently, at the same time the oxide semiconductor layer may readily peel away.

Preferably, the oxide semiconductor layer is composed of plural layers (at least two layers) that differ in the light transmittance; and more preferably, oxide semiconductor layers having a higher light transmittance are disposed nearer to the glass substrate in order. Accordingly, the radiated light could be effectively utilized and the power generation efficiency of the dye-sensitized solar cell may be thereby enhanced.

As a means for increasing the light transmittance of the oxide semiconductor layer, it is effective to reduce the particle size of the oxide particles constituting the oxide semiconductor, or to reduce the number of the oxide particles per the unit volume of the oxide semiconductor layer.

Preferably, the mean primary particle size of the oxide particles is at most 30 nm, at most 25 nm, particularly at most 20 nm.

Preferably, the oxide semiconductor layer comprises oxide particles containing titanium oxide. Regarding the crystalline phase of titanium oxide, preferred is anatase-type titanium oxide as excellent in the energy conversion efficiency. However, the oxide particles are not limited to titanium oxide and any others capable of exhibiting the properties as dye-sensitized solar cells can be used. For example, there may be mentioned zinc oxide, and the like.

The oxide semiconductor layer may be formed by applying an oxide semiconductor paste onto a conductive film and baking. As the coating method of the oxide semiconductor paste, there may be mentioned a screen printing method, a doctor blade method, a squeezing method, a spin coating method, a spraying method, and the like. In particular, a screen printing method is preferred as capable of uniformly forming a film having a thickness of a few $\mu$m to tens $\mu$m in a broad area.

The oxide semiconductor paste comprises mainly oxide particles, a solvent and a resin. The resin is added thereto for the purpose of controlling the viscosity of the paste. If desired, a surfactant, a thickener and the like may also be added thereto.

As the resin, acrylates (acrylic resins); cellulose compounds such as ethyl cellulose, carboxy cellulose, carboxymethyl cellulose, hydroxyethyl cellulose, etc., polyethylene glycol derivatives, nitrocellulose, polymethylstyrene, polyethylene carbonate, methacrylate, and the like, can be used. In particular, acrylates, ethyl cellulose and nitrocellulose are preferred as readily decomposable under heat.

As the solvent, N,N'-dimethylformamide (DMF), $\alpha$-terpineol, higher alcohols, $\gamma$-butyrolactone ($\gamma$-BL), tetralin, butyl carbitol acetate, ethyl acetate, isoamyl acetate, diethylene glycol monoethyl ether, diethylene glycol monoethyl ether acetate, benzyl alcohol, toluene, 3-methoxy-3-methylbutanol, triethylene glycol monomethyl ether, triethylene glycol dimethyl ether, dipropylene glycol monomethyl ether, dipropylene glycol monobutyl ether, tripropylene glycol monomethyl ether, tripropylene glycol monobutyl ether, propylene carbonate, dimethyl sulfoxide (DMSO), N-methyl-2-pyrrolidone, and the like, can be used. In particular, $\alpha$-terpineol is favorable as being highly viscous and having an excellent ability to dissolve resins, and the like.

The baking temperature of the oxide semiconductor paste is preferably from 400 to 600˚C, from 420 to 570˚C, particularly from 450 to 550˚C. When the temperature is lower than 400˚C, then the resin could not be completely burnt and the oxide particles could not bond together sufficiently, and therefore the battery performance may lower. On the other hand, when higher than 600˚C, then the glass substrate may readily deform and the stress to be generated by the shrinkage of the oxide semiconductor layer may be great, and therefore the layer may readily peel away.

Subsequently, the second aspect of the present invention is described in detail.

In the second aspect of the present invention, the strain point of the glass substrate is 525˚C or higher, but is preferably 540˚C or higher in consideration of the temperature fluctuation during film formation. When the strain point of the glass substrate is lower than 525˚C, then the substrate may thermally deform during film formation. In relation to the temperature for formation of the FTO film or the ATO film, the strain point of the glass substrate is preferably higher by at least 15˚C than the film formation temperature for the FTO film or the ATO film, more preferably by at least 30˚C. Here, the film formation temperature means the temperature of the glass substrate during film formation.

Such glass includes $SiO_2$-$Al_2O_3$-RO-$R'_2O$-based glass, $SiO_2$-$Al_2O_3$-$B_2O_3$-RO-based glass, $SiO_2$-$Al_2O_3$-$R'_2O$-based glass, $SiO_2$-$B_2O_3$-$R'_2O$-based glass, $SiO_2$-$B_2O_3$-$Al_2O_3$-RO-$R'_2O$-based glass and the like (wherein R means any of Mg, Ca, Sr, Ba and Zn; R' means any of Li, Na and K).

Here, $Al_2O_3$ and $ZrO_2$ are ingredients for elevating the strain point of glass; however, they may increase the high-temperature viscosity and may worsen the meltability of glass. On the other hand, alkali metal oxides such as $Li_2O$, $Na_2O$, $K_2O$ and the like are ingredients for lowering the high-temperature viscosity, but tend to lower the strain point.

MgO, CaO, SrO, BaO and ZnO are ingredients for lowering the high-temperature viscosity of glass; and they have a property not to lower the strain point so much as compared with alkali metal oxides. Accordingly, by suitably substituting the alkali metal oxides with these ingredients, the strain point of glass may be elevated with keeping the high-temperature viscosity of glass at a relatively low level.

For instance, as $SiO_2$-$Al_2O_3$-RO-R'$_2$O-based glass, a composition of, in terms of % by mass, from 50 to 70% of $SiO_2$, from 0.5 to 15% of $Al_2O_3$, from 10 to 27% of MgO + CaO + SrO + BaO + ZnO, from 7 to 15% of $Li_2O$ + $Na_2O$ + $K_2O$, from 0 to 9% of $ZrO_2$, from 0 to 5% of $TiO_2$, and from 0 to 1% of $SnO_2$ + $Sb_2O_3$ + $As_2O_3$ + $SO_3$, is exemplified.

The reason for the definition of the glass composition could be explained as follows.

$SiO_2$ is a network-constituting ingredient of glass, and its content is from 50 to 70%, preferably from 52 to 65%. When the $SiO_2$ content is less than 50%, then the strain point of glass tends to be low. On the other hand, when the $SiO_2$ content is more than 70%, then the melting temperature may be high and the meltability may worsen and the composition may readily devitrify.

$Al_2O_3$ is an ingredient for elevating the strain point of glass, and its content is from 0.5 to 15%, preferably from 2 to 12%. When the $Al_2O_3$ content is less than 0.5%, then the effect of elevating the strain point could hardly be attained. On the other hand, when the $Al_2O_3$ content is more than 15%, then the melting temperature becomes high and the meltability may worsen and the composition may readily devitrify.

MgO, CaO, SrO, BaO and ZnO are all ingredients for enhancing the meltability of glass, at the same time for controlling the thermal expansion coefficient. As already described, these ingredients have a property not to lower the strain point so much as compared with alkali metal oxides. The content of these ingredients is from 10 to 27% in total, preferably from 15 to 25%. When the total content of these ingredients is less than 10%, then the melting temperature becomes high and the meltability may worsen; on the other hand however, when more than 27%, then the composition may readily devitrify and its forming may be difficult.

$Li_2O$, $Na_2O$ and $K_2O$ are all ingredients for enhancing the meltability of glass, at the same time for controlling the thermal expansion coefficient. The content of these ingredients is from 7 to 15% in total, preferably from 8 to 13%. When the total content of these ingredients is less than 7%, then the melting temperature becomes high and the meltability may worsen; on the other hand however, when more than 15%, then the strain point may be low.

$ZrO_2$ is an ingredient for elevating the strain point and for enhancing the chemical durability. The content of $ZrO_2$ is from 0 to 9%, preferably from 1 to 7%. When the $ZrO_2$ content is more than 9%, then a devitrified matter may form in melting and the composition may be difficult to be formed.

$TiO_2$ is an ingredient for preventing glass from being colored by UV rays (solarization). In case where the glass substrate contains an iron ion as an impurity (for example, in an amount of from 0.01 to 0.2%) and when the solar cell comprising the glass substrate is used for a long period of time, then the iron ion may cause coloration. Thus, adding $TiO_2$ thereto may prevent the coloration of this type. The $TiO_2$ content is from 0 to 5%, preferably from 1 to 4%. When the $TiO_2$ content is more than 5%, then the composition may readily devitrify and its forming may be difficult.

$SnO_2$, $Sb_2O_3$, $As_2O_3$ and $SO_3$ are all ingredients serving as a fining agent. The content of these ingredients is from 0 to 1% in total, preferably from 0.1 to 0.8%. When the total content of these ingredients is more than 1%, then the composition may readily devitrify and its forming may be difficult.

In addition, as $SiO_2$-$Al_2O_3$-$B_2O_3$-RO-based glass having a higher strain point, a composition of, in terms of % by mass, from 50 to 70% of $SiO_2$, from 10 to 20% of $Al_2O_3$, from 9 to 15% of $B_2O_3$, from 10 to 18% of MgO + CaO + SrO + BaO, from 0.05 to 1% of $SnO_2$ + $Sb_2O_3$ + $As_2O_3$, is exemplified.

The reason for the definition of the glass composition could be explained as follows.

$SiO_2$ is a network-constituting ingredient of glass. The $SiO_2$ content is from 50 to 70%, preferably from 55 to 65%. When the $SiO_2$ content is less than 50%, then the strain point may be low. On the other hand, when the $SiO_2$ content is more than 70%, then the melting temperature becomes high and the meltability may worsen and the composition may readily devitrify.

$Al_2O_3$ is an ingredient for elevating the strain point of glass. The $Al_2O_3$ content is from 10 to 20%, preferably from 12 to 18%. When the $Al_2O_3$ content is less than 10%, then the effect of elevating the strain point could hardly be attained. On the other hand, when the $Al_2O_3$ content is more than 20%, then the melting temperature becomes high and the meltability may worsen and the composition may readily devitrify.

$B_2O_3$ serves as a flux, and lowers the viscosity of glass to facilitate the melting. The content of $B_2O_3$ is from 9 to 15%, preferably from 9 to 14%. When the $B_2O_3$ content is less than 9%, then the effect as the flux may be insufficient. On the other hand, when the $B_2O_3$ content is more than 15%, then the strain point may lower.

MgO, CaO, SrO, BaO and ZnO are all ingredients for enhancing the meltability of glass, at the same time for controlling the thermal expansion coefficient thereof As already described, these ingredients have a property not to lower the strain point so much as compared with alkali metal oxides. The content of these ingredients is from 10 to 18% in total, preferably from 11 to 16%. When the total content of these ingredients is less than 10%, then the melting temperature becomes high and the meltability may worsen; on the other hand however, when more than 18%, then the composition may readily devitrify and its forming may be difficult. In this connection, preferably, the content of MgO is from 0 to 2.5% (more preferably from 0.1 to 2%), that of CaO is from 6.5 to 15% (more preferably from 7 to 13%), that of SrO is from 3 to 10% (more preferably from 3 to 8%), and that of BaO is from 0 to 3% (more preferably from 0.1 to 2%).

$SnO_2$ $Sb_2O_3$ and $As_2O_3$ are all ingredients serving as a fining agent. The content of these ingredients is from 0.05 to 1% in total. When the total content of these ingredients is less than 0.05%, then sufficient effect as a fining agent can not be attained; on the other hand however, when more than 1%, then the composition may readily devitrify.

In the second aspect of the present invention, the thickness of the glass substrate is from 0.05 to 2 mm, preferably from 0.1 to 1.5 mm, more preferably from 0.2 to 1.2 mm. When the thickness of the glass substrate is more than 2 mm, then it would be difficult to make solar cells thin and light. On the other hand, when the glass substrate is thinner than 0.05 mm, though its softness (flexibility) may be excellent, its strength may lower and it may be readily broken.

In the second aspect of the present invention, the conductive film comprises fluorine-doped tin oxide (FTO) or antimony-doped tin oxide (ATO). Regarding the staring materials for the FTO film and the ATO film to be formed according to a film formation method such as a thermal CVD method or the like, $SnCl_4$, $C_4H_9SnCl_3$, $(CH_3)_2SnCl_2$ and the like can be used as the tin source; HF, $CF_3COOH$, $CHF_2$, $CCl_2F_2$ and the like can be used as the fluorine source; and $SbCl_3$ and the like can be used as the antimony source.

The thickness of the FTO film and the ATO film is not particularly limited, but is preferably controlled to fall within a range of from 0.5 to 1.5 $\mu$m. When the thickness of the FTO film and the ATO film is less than 0.5 $\mu$m, then sufficient conductivity can not be attained; on the other hand however, when more than 1.5 $\mu$m, then the sunlight spectral transmittance may be low and the power generation efficiency of the solar cell may lower.

The resistance of the FTO film and the ATO film is preferably at most 10 $\Omega$/square, more preferably at most 7 $\Omega$/square. When the resistance of the film is more than 10 $\Omega$/square, then the conductivity of the film may lower and the performance as the solar cell tends to worsen.

The mean surface roughness (Ra) of the FTO film and the ATO film is preferably at least 20 nm, more preferably at least 30 nm. The mean surface roughness of the film falling within the range facilitates the light trapping effect and increases the surface area of the film, therefore enhancing the conductivity.

In case where the glass substrate comprises glass that contains an alkali metal oxide, an undercoat layer of $SiO_2$ or the like may be provided between the FTO film or the ATO film and the glass substrate. The undercoat layer prevents the situations in which alkali ion is eluted from glass to lower the conductivity of the FTO film or the ATO film.

In the second aspect of the present invention, when the solar cell substrate is used for dye-sensitized solar cells, the thermal expansion coefficient of the glass substrate is preferably controlled to fall within a range of from $70 \times 10^{-7}$ to $110 \times 10^{-7}$/°C. As described in the above, when the thermal expansion coefficient of the glass substrate is less than $70 \times 10^{-7}$/°C, then the difference in the thermal expansion coefficient with the low-melting-point glass for sealing is large, and thus, the sealed part or the glass substrate may be cracked therefore causing leakage of iodine electrolytic solution. On the other hand, when the thermal expansion coefficient of the glass substrate is more than $110 \times 10^{-7}$/°C, then the substrate may undergo thermal deformation in film formation of the FTO film or the ATO film.

In case where any other sealant than low-melting-point glass, such as resin or the like, is used for sealing the glass substrate, the thermal expansion coefficient of the glass substrate is not limited to the above range, and for example, a glass substrate having a thermal expansion coefficient of from $-5 \times 10^{-7}$ to $110 \times 14^{-7}$/°C, or from $30 \times 10^{-7}$ to $110 \times 10^{-7}$/°C can be used. In particular, a glass substrate having a thermal expansion coefficient smaller than $70 \times 10^{-7}$/°C can be used; and concretely, a glass substrate having a thermal expansion coefficient of at most $60 \times 10^{-7}$/°C, or at most $50 \times 10^{-7}$/°C can be used.

In the oxide semiconductor electrode for dye-sensitized solar cell of the present invention, the thickness of the oxide semiconductor layer is from 5 to 50 $\mu$m, preferably from 8 to 40 $\mu$m, more preferably from 10 to 30 $\mu$m. When the thickness of the oxide semiconductor layer is less than 5 $\mu$m, then the power generation efficiency of the dye-sensitized solar cell may lower. On the other hand, when the thickness of the oxide semiconductor layer is more than 50 $\mu$m, then it is difficult to utilize the radiated light efficiently and the oxide semiconductor layer may readily peel away.

The oxide semiconductor layer is composed of a single layer or plural layers (at least two layers) that differ in the light transmittance.

It is known that, when an oxide semiconductor layer is composed of plural layers (at least two layers) that differ in the light transmittance, and when oxide semiconductor layers having a higher light transmittance are disposed nearer to the glass substrate in order, then the radiated light could be effectively utilized and the power generation efficiency of the dye-sensitized solar cell may be thereby enhanced. On the other hand, in this constitution, the stress to act between the oxide semiconductor layer and the glass substrate may increase owing to the difference in the sintering behavior between the layers, and therefore the oxide semiconductor layer may readily peel away. In particular, in the case where the thermal expansion coefficient of the glass substrate is small (for example, less than $70 \times 10^{-7}$/°C, at most $60 \times 10^{-7}$/°C, or at most $50 \times 10^{-7}$/°C), the peeling of the oxide semiconductor layer would be remarkable. From the viewpoint of preventing the peeling of the oxide semiconductor layer, it is desirable that the oxide semiconductor layer is composed of a single layer.

As a means for increasing the light transmittance of the oxide semiconductor layer, it is effective to reduce the particle size of the oxide particles constituting the oxide semiconductor.

Preferably, the mean primary particle size of the oxide particles is at most 30 nm, more preferably at most 25 nm, even more preferably at most 20 nm. When the mean primary particle size of the oxide particles is more than 30 nm, then the light transmittance of the oxide semiconductor layer may be poor.

The porosity of the oxide semiconductor layer is preferably from 60 to 80%, more preferably from 65 to 75%. When the porosity of the oxide semiconductor layer is less than 60%, then the layer may readily peel away owing to the stress to occur in baking, and in addition, since the layer could not adsorb a sufficient amount of dye, the power generation efficiency may lower. When the porosity of the oxide semiconductor layer is more than 80%, the number of effective oxide semiconductor particles may reduce or the paths for electron movement may reduce whereby the power generation efficiency may lower. In addition, the mechanical strength of the film may lower and the layer would peel away even when a slight external impact load is given thereto.

Preferably, the oxide semiconductor layer comprises oxide particles containing titanium oxide. Regarding the crystalline phase of titanium oxide, preferred is anatase-type titanium oxide as excellent in the energy conversion efficiency. However, the oxide particles are not limited to titanium oxide and any others capable of exhibiting the properties as dye-sensitized solar cells can be used. For example, there may be mentioned zinc oxide, and the like.

The oxide semiconductor layer may be formed by applying an oxide semiconductor paste onto a conductive film and then baking the paste. As the coating method of the oxide semiconductor paste, there may be mentioned a screen printing method, a doctor blade method, a squeezing method, a spin coating method, a spraying method, and the like. In particular, a screen printing method is preferred as capable of uniformly forming a film having a thickness of a few $\mu$m to tens $\mu$m in a broad area.

The oxide semiconductor paste comprises mainly oxide particles, a solvent and a resin. The resin is added thereto for the purpose of controlling the viscosity of the paste. If desired, a surfactant, a thickener and the like may also be added thereto.

As the resin, acrylates (acrylic resins); cellulose compounds such as ethyl cellulose, carboxy cellulose, carboxymethyl cellulose, hydroxyethyl cellulose, and the like; polyethylene glycol derivatives, nitrocellulose, polymethylstyrene, polyethylene carbonate, methacrylates, and the like, can be used. In particular, acrylates, ethyl cellulose and nitrocellulose are preferred as readily decomposable under heat.

As the solvent, N,N'-dimethylformamide (DMF), $\alpha$-terpineol, higher alcohols, $\gamma$-butyrolactone ($\gamma$-BL), tetralin, butyl carbitol acetate, ethyl acetate, isoamyl acetate, diethylene glycol monoethyl ether, diethylene glycol monoethyl ether acetate, benzyl alcohol, toluene, 3-methoxy-3-methylbutanol, triethylene glycol monomethyl ether, triethylene glycol dimethyl ether, dipropylene glycol monomethyl ether, dipropylene glycol monobutyl ether, tripropylene glycol monomethyl ether, tripropylene glycol monobutyl ether, propylene carbonate, dimethyl sulfoxide (DMSO), N-methyl-2-pyrrolidone, and the like, can be used. In particular, $\alpha$-terpineol is favorable as being highly viscous and having a good ability to dissolve resins, and the like.

The baking temperature of the oxide semiconductor paste is preferably from 400 to 600˚C, from 420 to 570˚C, particularly from 450 to 550˚C. When the temperature is lower than 400˚C, then the resin could not be completely burnt and the oxide particles could not bond together sufficiently, and therefore the battery performance may lower. On the other hand, when higher than 600˚C, then the glass substrate may readily deform and the stress to be generated by the shrinkage of the oxide semiconductor layer may be great, and therefore the layer may readily peel away.

The size of the solar cell substrate of the present invention is not specifically limited and may be suitably selected in accordance with the intended use. When the size of the substrate is larger, the temperature distribution unevenness in film formation may occur more frequently and the substrate may often undergo thermal deformation, and thus, the effect of the present invention is more remarkable. Concretely, the present invention is effective when the area of the conductive film-deposited glass substrate is 1000 mm$^2$ or more, more effectively 5000 mm$^2$ or more, even more effectively 10000 mm$^2$ or more.

EXAMPLES

Hereinafter, the present invention is described with reference to Examples, however, the present invention should not be limited to these Examples.

The first aspect of the present invention is described with reference to Examples. Glass substrates (100 mm $\times$ 100 mm) having the composition, the thickness, the thermal expansion coefficient and the strain point shown in Table 1 were prepared. The thermal expansion coefficient is a value measured with a dilatometer. The strain point is a value measured with DTA.

Subsequently, an FTO film as a conductive film (having a thickness of 1 $\mu$m) was formed on each glass substrate, according to a thermal CVD method using dimethyltin chloride and trifluoroacetic acid at a film formation temperature of 510˚C.

The obtained conductive film-deposited glass substrate was gradually cooled, then put on a surface plate and checked for the presence or absence of deformation with a clearance gauge. When the deformation was less than 0.1 mm, the samples were evaluated as "O"; and when 0.1 mm or more, the samples were evaluated as "x". Thus, the conductive film-deposited glass substrates were evaluated for the condition thereof The results are shown in Table 1.

The conductive film-deposited glass substrate was cut into a size of 15 mm $\times$ 15 mm, and a titanium oxide paste was screen-printed thereon using a 200-mesh screen. As the titanium oxide paste, used were Solaronix's Ti-Nanoxide T/SP (hereinafter referred to as T/SP, having a mean particle size of 13 nm), which is semitransparent after baked, and the company's Ti-Nanoxide D/SP (hereinafter referred to as D/SP, having a mean particle size of 13 nm (partly containing particles having a mean particle size of 400 nm)), which is nontransparent after baked. The titanium oxide paste was printed on the conductive film-deposited glass substrate (on the conductive film surface) in order of T/SP and D/SP thereon, and baked in an electric furnace at 500°C for 30 minutes. The thickness of T/SP was 6 $\mu$m and that of D/SP was 14 $\mu$m, and the overall thickness of the film was 20 $\mu$m.

Next, Scotch Mending Tape 810 was stuck to the baked titanium oxide layer, pressed with a rubber roller, and the tape was peeled away at once to thereby confirm the adhesiveness between the glass substrate (conductive film surface) and the titanium oxide layer. The degree of adhesiveness between the titanium oxide layer and the glass substrate (conductive film surface) was determined, based on the ratio of the exposed area of the glass substrate (conductive film surface) from which the titanium oxide layer had been peeled away, to the printed area of the titanium oxide layer. "A" is given to the samples having the ratio of from 0 to less than 10%; "B" is to the samples having the ratio of from 10 to less than 30%; "C" is to the samples having the ratio of from 30 to less than 80%; and "D" is to the samples having the ratio of from 80 to 100%. The samples given A and B are excellent. The results are shown in Table 1.

[Table 1]

| | | Example | | | | Comparative Example | |
|---|---|---|---|---|---|---|---|
| | | 1 | 2 | 3 | 4 | 1 | 2* |
| Glass Composition (% by mass) | $SiO_2$ | 56.8 | 55.2 | 68.3 | 70.6 | 59.0 | 64.3 |
| | $Al_2O_3$ | 13 | 7.0 | 5.0 | 6.0 | 16.5 | 22.0 |
| | $B_2O_3$ | 2.0 | | 11.0 | 12.6 | 10.5 | 0.5 |
| | MgO | 2.0 | 2.0 | | | 0.5 | 1.0 |
| | CaO | 2.0 | 2.0 | 3.0 | 0.8 | 8.0 | |
| | SrO | | 9.0 | | | 4.5 | |
| | BaO | | 8.5 | | 2.0 | 0.5 | |
| | ZnO | | | 1.0 | | | 1.2 |
| | $Li_2O$ | | | | | | 4.2 |
| | $Na_2O$ | 15.0 | 4.5 | 11.0 | 6.5 | | 0.4 |
| | $K_2O$ | 5.0 | 7.0 | 0.5 | 1.4 | | 0.3 |
| | $TiO_2$ | | | | | | 2.0 |
| | $ZrO_2$ | 4.0 | 4.5 | | | | 2.1 |
| | $P_2O_5$ | | | | | | 1.5 |
| | $Fe_2O_3$ | | 0.1 | | | | |
| | $SO_3$ | | 0.2 | | | | |
| | $Sb_2O_3$ | 0.2 | | 0.2 | 0.1 | 0.5 | 0.5 |
| Total | | 100 | 100 | 100 | 100 | 100 | 100 |
| Thickness of Glass Substrate (mm) | | 1.1 | 1.1 | 1.1 | 1.8 | 1.1 | 1.1 |
| Thermal Expansion Coefficient ($\times 10^{-7}$/°C) Coefficient | | 100 | 83 | 66 | 52 | 38 | -1 |
| Strain Point (°C) | | 530 | 580 | 540 | 525 | 650 | - |
| Deformation of Glass | | ○ | ○ | ○ | ○ | ○ | ○ |
| Adhesiveness | | A | A | B | B | D | D |
| *: Comparative Example 2 is low-expansion crystallized glass. | | | | | | | |

In Examples 1 to 4, the thermal expansion coefficient of the glass substrate was from $50 \times 10^{-7}$ to $110 \times 10^{-7}$/°C, and therefore, the adhesiveness of the titanium oxide layer was all on the level of "A" or "B", and was excellent. On the other hand, in Comparative Examples 1 and 2, the thermal expansion coefficient of the glass substrate was smaller than $50 \times 10^{-7}$/°C, and therefore, the adhesiveness was bad and was on the level of "D". Especially in Comparative Example 2, the titanium oxide layer peeled away from the glass substrate (conductive film surface) before the tape peeling test, was visible to the naked eye.

Subsequently, the second aspect of the present invention is described with reference to Examples.

(Examples 5 to 8, and Comparative Examples 3 and 4)

An FTO film as a conductive film was formed on each glass substrate (120 mm × 120 mm) shown in Table 1, according to a thermal CVD method. Concretely, $(CH_3)_2SnCl_2$ and $CF_3COOH$ were used as the starting materials. These were once gasified, and sprayed onto the glass substrate heated at the film formation temperature shown in Table 1, thereby forming a film to produce a conductive film-deposited glass substrate. Prior to film formation, the glass substrate was kept heated at the film formation temperature for 10 minutes. The film formation time was so controlled within a range of from 2 to 5 minutes that the thickness of the FTO film formed could be about 1 μm.

The obtained conductive film-deposited glass substrate was gradually cooled, and the thus-cooled conductive film-deposited glass substrate was put on a surface plate and checked for the presence or absence of deformation with a clearance gauge. When the deformation was less than 0.1 mm, the samples were evaluated as "O"; and when 0.1 1 mm or more, the samples were evaluated as "×". Thus, the conductive film-deposited glass substrates were evaluated for the condition thereof The results are shown in Table 2.

[Table 2]

| | | Example | | | | Comparative Example | |
|---|---|---|---|---|---|---|---|
| | | 5 | 6 | 7 | 8 | 3 | 4 |
| Composition (% by mass) | $SiO_2$ | 55.2 | 59.0 | 68.3 | 56.8 | 72.8 | 72.2 |
| | $Al_2O_3$ | 7.0 | 16.5 | 5.0 | 13.0 | 2.0 | 1.6 |
| | $B_2O_3$ | | 10.5 | 11.0 | 2.0 | | |
| | MgO | 2.0 | 0.5 | | 2.0 | 1.5 | 4.0 |
| | CaO | 2.0 | 8.0 | 3.0 | 2.0 | 8.2 | 8.0 |
| | SrO | 9.0 | 4.5 | | | | |
| | BaO | 8.5 | 0.5 | | | | |
| | ZnO | | | 1.0 | | | |
| | $Na_2O$ | 4.5 | | 11.0 | 15.0 | 14.0 | 13.1 |
| | $K_2O$ | 7.0 | | 0.5 | 5.0 | 1.0 | 1.0 |
| | $TiO_2$ | | | | | 0.2 | |
| | $ZrO_2$ | 4.5 | | | 4.0 | | |
| | $SO_3$ | 0.2 | | | | 0.2 | |
| | $Fe_2O_3$ | 0.1 | | | | 0.1 | 0.1 |
| | $Sb_2O_3$ | | 0.5 | 0.2 | 0.2 | | |
| | Total | 100.0 | 100.0 | 100.0 | 100.0 | 100.0 | 100.0 |
| Strain Point (˚C) | | 580 | 650 | 540 | 530 | 500 | 510 |
| Thermal Expansion Coefficient ($\times 10^{-7}$/˚C) | | 83 | 38 | 66 | 100 | 92 | 85 |
| Thickness(mm) | | 1.0 | 0.5 | 0.7 | 1.0 | 2.0 | 2.0 |
| Film Formation Temperature (˚C) | | 540 | 590 | 520 | 510 | 510 | 510 |
| Condition of Glass Substrate | | ○ | ○ | ○ | ○ | × | × |

In Examples 5 to 8, the strain point of the conductive film-deposited glass substrate was at least 525˚C and therefore, no deformation of the samples after film formation thereon was confirmed. On the other hand, in Comparative Examples 3 and 4, deformation of 0.5 mm or more was confirmed though the thickness of the glass substrate was larger and the film formation temperature was lower than in Examples 5 to 8.

(Examples 9 to 13)

The conductive film-deposited glass substrates of Examples 5 and 6 were cut into a size of 15 mm × 15 mm; and using a 200-mesh screen, a titanium oxide paste was screen-printed on the conductive films. As the titanium oxide paste, used were Solaronix's Ti-Nanoxide T/SP (hereinafter referred to as T/SP, having a mean particle size of 13 nm), which is semitransparent after baked, and the company's Ti-Nanoxide D/SP (hereinafter referred to as D/SP, having a mean particle size of 13 nm (partly containing particles having a mean particle size of 400 nm)), which is nontransparent after baked. In Examples 9 and 11, D/SP alone was screen-printed; in Examples 10 and 12, T/SP alone was screen-printed; and in Example 13, T/SP and D/SP were screen-printed in this order. These were baked in an electric furnace at 500˚C for 30 minutes.

Next, Scotch Mending Tape 810 was stuck to the baked titanium oxide layer, pressed with a rubber roller, and the tape was peeled away at once to thereby confirm the adhesiveness between the glass substrate (conductive film surface) and the titanium oxide layer. The degree of adhesiveness between the titanium oxide layer and the glass substrate (conductive film surface) was determined, based on the ratio of the exposed area of the glass substrate (conductive film surface) from which the titanium oxide layer had been peeled away, to the printed area of the titanium oxide layer. "A" is given to the samples having the ratio of from 0 to less than 10%; "B" is to the samples having the ratio of from 10 to less than 30%; "C" is to the samples having the ratio of from 30 to less than 80%; and "D" is to the samples having the ratio of from 80 to 100%. The samples given A and B are excellent. The results are shown in Table 3.

[Table 3]

| | | Example | | | | |
|---|---|---|---|---|---|---|
| | | 9 | 10 | 11 | 12 | 13 |
| Glass Substrate | Type | Example 5 | Example 5 | Example 6 | Example 6 | Example 6 |
| | Strain Point of, Substrate (˚C) | 580 | 580 | 650 | 650 | 650 |
| | Thermal Expansion Coefficient ($\times 10^-$ Coemcient($\times 10^{-7}$/˚C) | 83 | 83 | 38 | 38 | 38 |
| First Titania Layer | Type | D/SP | T/SP | D/SP | T/SP | T/SP |
| | Mean Primary Particle Size (nm) | 13 | 13 | 13 | 13 | |
| | Thickness ($\mu$m) | 20 | 18 | 20 | 18 | 6 |
| Second Titania Layer | Type Mean Primary | - | - | - | - | D/SP |
| | Particle Size (nm) | - | - | - | - | 13 |
| | Thickness ($\mu$m) | - | - | - | - | 14 |
| Porosity (%) | | 68 | 67 | 68 | 67 | 68 |
| Adhesiveness | | A | A | A | A | D |

While the present invention has been described in detail with reference to specific embodiments, it will be apparent to one skilled in the art that various changes and modifications can be made therein without departing from the spirit and scope of the present invention.

The present application is based on a Japanese patent application (No. 2008-157645) filed on June 17, 2008, a Japanese patent application (No. 2008-240955) filed on September 19, 2008, and a Japanese patent application (No. 2008-258761) filed on October 3, 2008, the entire contents thereof being hereby incorporated by reference.

INDUSTRIAL APPLICABILITY

The solar cell substrate of the present invention is favorable as electrode substrates for use in silicon-based thin-film solar cells such as typically amorphous silicon solar cells, as well as dye-sensitized solar cells, CdTe solar cells and the like, and is especially favorable for electrode substrates for use in dye-sensitized solar cells.

**Claims**

1.    A solar cell substrate comprising a transparent conductive film formed on a glass substrate, wherein the thermal expansion coefficient of the glass substrate is from $50 \times 10^{-1}$ to $110 \times 10^{-7}$/˚C,

2.   The solar cell substrate as claimed in claim 1, wherein the solar cell is a dye-sensitized solar cell.

3.   The solar cell substrate as claimed in claim 1 or 2, wherein the strain point of the glass substrate is 525˚C or higher.

4.   The solar cell substrate as claimed in any one of claims 1 to 3, wherein the thickness of the glass substrate is at most 2 mm.

5.   An oxide semiconductor electrode for dye-sensitized solar cell comprising an oxide semiconductor layer having a thickness of from 5 to 50 $\mu$m formed on the transparent conductive film of the solar cell substrate as claimed in any one of claims 1 to 4.

6.   The oxide semiconductor electrode for dye-sensitized solar cell as claimed in claim 5, wherein the oxide semiconductor layer contains titanium oxide.

7.   The oxide semiconductor electrode for dye-sensitized solar cell as claimed in claim 5 or 6, wherein the oxide semiconductor layer comprises plural layers having different light transmittance.

8.   The oxide semiconductor electrode for dye-sensitized solar cell as claimed in any one of claims 5 to 7, wherein the oxide semiconductor layer comprises plural layers having different particle size distribution for the oxide particles.

9.   The oxide semiconductor electrode for dye-sensitized solar cell as claimed in any one of claims 5 to 8, wherein the oxide semiconductor layer contains a layer comprising oxide particles having a mean primary particle size of at most 30 nm.

10.  A solar cell substrate comprising a conductive film of fluorine-doped tin oxide or antimony-doped tin oxide formed on a glass substrate having a thickness of from 0.05 to 2 mm, wherein the strain point of the glass substrate is 525˚C or higher.

11.  The solar cell substrate as claimed in claim 10, wherein the solar cell is a dye-sensitized solar cell.

12.  The solar cell substrate as claimed in claim 10 or 11, wherein the thermal expansion coefficient of the glass substrate is from $70 \times 10^{-7}$ to $110 \times 10^{-7}$/˚C.

13.  An oxide semiconductor electrode for dye-sensitized solar cell comprising an oxide semiconductor layer having a thickness of from 5 to 50 $\mu$m formed on the conductive film of the solar cell substrate as claimed in any one of claims 10 to 12.

14.  The oxide semiconductor electrode for dye-sensitized solar cell as claimed in claim 13, wherein the oxide semiconductor layer comprises oxide particles having a mean primary particle size of at most 30 nm.

15.  The oxide semiconductor electrode for dye-sensitized solar cell as claimed in claim 13 or 14, wherein the porosity of the oxide semiconductor layer is from 60 to 80%.

<table>
<tr><td colspan="2" align="center">**INTERNATIONAL SEARCH REPORT**</td><td colspan="2">International application No.<br><br>PCT/JP2009/064265</td></tr>
<tr><td colspan="4">A.  CLASSIFICATION OF SUBJECT MATTER<br>*H01M14/00*(2006.01)i, *H01L31/04*(2006.01)i<br><br><br>According to International Patent Classification (IPC) or to both national classification and IPC</td></tr>
<tr><td colspan="4">B.  FIELDS SEARCHED</td></tr>
<tr><td colspan="4">Minimum documentation searched (classification system followed by classification symbols)<br>H01M14/00, H01L31/04<br><br><br></td></tr>
<tr><td colspan="4">Documentation searched other than minimum documentation to the extent that such documents are included in the fields searched<br>  Jitsuyo Shinan Koho       1922–1996   Jitsuyo Shinan Toroku Koho   1996–2009<br>  Kokai Jitsuyo Shinan Koho   1971–2009   Toroku Jitsuyo Shinan Koho   1994–2009</td></tr>
<tr><td colspan="4">Electronic data base consulted during the international search (name of data base and, where practicable, search terms used)<br><br><br></td></tr>
</table>

C.  DOCUMENTS CONSIDERED TO BE RELEVANT

| Category* | Citation of document, with indication, where appropriate, of the relevant passages | Relevant to claim No. |
|---|---|---|
| X<br>Y | JP 11-135819 A  (Matsushita Electric Industrial Co., Ltd.),<br>21 May 1999 (21.05.1999),<br>claims; paragraphs [0014] to [0025]; fig. 4<br>(Family: none) | 1,3-4,10,12<br>2,5-9,11,<br>13-15 |
| X<br>Y | JP 2007-42366 A  (Fujikura Ltd.),<br>15 February 2007 (15.02.2007),<br>claims; paragraphs [0014] to [0016], [0026], [0033] to [0034]<br>& US 2008/0169022 A1     & EP 1919023 A1<br>& WO 2007/015342 A1 | 1-6,9-15<br>7-8 |

<table>
<tr><td>&#9746;  Further documents are listed in the continuation of Box C.</td><td>&#9744;  See patent family annex.</td></tr>
<tr><td>
*    Special categories of cited documents:<br>
"A"   document defining the general state of the art which is not considered to be of particular relevance<br>
"E"   earlier application or patent but published on or after the international filing date<br>
"L"   document which may throw doubts on priority claim(s) or which is cited to establish the publication date of another citation or other special reason (as specified)<br>
"O"   document referring to an oral disclosure, use, exhibition or other means<br>
"P"   document published prior to the international filing date but later than the priority date claimed
</td><td>
"T"   later document published after the international filing date or priority date and not in conflict with the application but cited to understand the principle or theory underlying the invention<br>
"X"   document of particular relevance; the claimed invention cannot be considered novel or cannot be considered to involve an inventive step when the document is taken alone<br>
"Y"   document of particular relevance; the claimed invention cannot be considered to involve an inventive step when the document is combined with one or more other such documents, such combination being obvious to a person skilled in the art<br>
"&"   document member of the same patent family
</td></tr>
<tr><td>Date of the actual completion of the international search<br>   30 October, 2009 (30.10.09)</td><td>Date of mailing of the international search report<br>   10 November, 2009 (10.11.09)</td></tr>
<tr><td>Name and mailing address of the ISA/<br>   Japanese Patent Office</td><td>Authorized officer</td></tr>
<tr><td>Facsimile No.</td><td>Telephone No.</td></tr>
</table>

Form PCT/ISA/210 (second sheet) (April 2007)

**INTERNATIONAL SEARCH REPORT**

| International application No. |
|---|
| PCT/JP2009/064265 |

C (Continuation).   DOCUMENTS CONSIDERED TO BE RELEVANT

| Category* | Citation of document, with indication, where appropriate, of the relevant passages | Relevant to claim No. |
|---|---|---|
| X<br>Y | JP 2007-311242 A  (Fujikura Ltd.),<br>29 November 2007 (29.11.2007),<br>claims; paragraphs [0019], [0037], [0045]<br>& US 2009/0133743 A      & EP 2023435 A1<br>& WO 2007/135949 A1 | 1-6,9-15<br>7-8 |
| Y | JP 2003-142170 A  (Toyota Central Research and<br>Development Laboratories, Inc.),<br>16 May 2003 (16.05.2003),<br>claims; paragraphs [0051] to [0052]; fig. 1<br>(Family: none) | 2,5-9,11,<br>13-15 |
| Y | JP 2003-217688 A  (Sharp Corp.),<br>31 July 2003 (31.07.2003),<br>claims; fig. 1<br>& US 2002/0134426 A1 | 2,5-9,11,<br>13-15 |
| Y | JP 2001-93591 A  (Toshiba Corp.),<br>06 April 2001 (06.04.2001),<br>claims; paragraph [0025]; fig. 2<br>(Family: none) | 2,5-9,11,<br>13-15 |

Form PCT/ISA/210 (continuation of second sheet) (April 2007)

## INTERNATIONAL SEARCH REPORT

International application No.

PCT/JP2009/064265

| Box No. II | Observations where certain claims were found unsearchable (Continuation of item 2 of first sheet) |
| --- | --- |

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

| Box No. III | Observations where unity of invention is lacking (Continuation of item 3 of first sheet) |
| --- | --- |

This International Searching Authority found multiple inventions in this international application, as follows:
```
   In order that a group of inventions stated in the claims complies with the
requirement of unity of invention, a special technical feature for linking
the group of inventions so as to form a single general inventive concept should
exist.  A group of inventions of claims 1 to 9 is linked through matter stated
in claim 1.  On the other hand, a group of inventions of claims 10 to 15 is
linked through matter stated in claim 10.
   Accordingly, the group of inventions of claims 1 to 9 and the group of inventions
of claims 10 to 15 are not so linked as to form a single general inventive
concept.
                    (continued to extra sheet)
```

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

**INTERNATIONAL SEARCH REPORT**

International application No.

PCT/JP2009/064265

Continuation of Box No.III of continuation of first sheet(2)

Thus, the claims in the international application include at least two inventions classified into the group of inventions of claims 1 to 9 and the group of inventions of claims 10 to 15.

Form PCT/ISA/210 (extra sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002260448 A
- US 2008157645 A
- JP 2008240955 A
- JP 2008258761 A

**Non-patent literature cited in the description**

- Technology of Transparent Conductive Film. Ohm-sha, Ltd, 153-165